(19) Europäisches Patentamt
European Patent Office
Office européen des brevets

(11) **EP 1 975 990 A1**

(12) **EUROPEAN PATENT APPLICATION**
published in accordance with Art. 158(3) EPC

(43) Date of publication:
**01.10.2008 Bulletin 2008/40**

(21) Application number: **06842998.4**

(22) Date of filing: **21.12.2006**

(51) Int Cl.:
*H01L 21/322* (2006.01)        *C30B 29/06* (2006.01)
*C30B 33/02* (2006.01)

(86) International application number:
**PCT/JP2006/325490**

(87) International publication number:
**WO 2007/083477 (26.07.2007 Gazette 2007/30)**

(84) Designated Contracting States:
**DE FR**

(30) Priority: **17.01.2006 JP 2006008208**

(71) Applicant: **Shin-Etsu Handotai Co., Ltd.**
**Tokyo 100-0004 (JP)**

(72) Inventor: **EBARA, Koji,**
**Shin-Etsu Handotai Co., Ltd.**
**Annaka-shi, Gunma 3790796 (JP)**

(74) Representative: **Wibbelmann, Jobst et al**
**Wuesthoff & Wuesthoff**
**Patent- und Rechtsanwälte**
**Schweigerstrasse 2**
**81541 München (DE)**

(54) **METHOD FOR MANUFACTURING SILICON SINGLE CRYSTAL WAFER**

(57)    The present invention provides a method for manufacturing a silicon single crystal wafer by which a silicon single crystal ingot is pulled based on a Czochralski method and a rapid thermal annealing is performed with respect to a wafer that is sliced out from the silicon single crystal ingot and has a whole area in a radial direction formed of N region, wherein a heat treatment at 800 to 1100°C as a heat treatment temperature for two hours or below as a hear treatment time is carried out after the rapid thermal annealing while adjusting the heat treatment temperature and the heat treatment time so that at least diffusion distances of vacancies as point defects injected by the rapid thermal annealing become longer than diffusion distances of the vacancies by a heat treatment performed at 800°C for 30 minutes, thereby annihilating a vacancy type defect. As a result, there is provided the manufacturing method capable of inexpensively manufacturing a silicon wafer that can assure a DZ layer with a sufficient thickness in a wafer front surface layer region and can also assure a sufficient quantity of oxide precipitates functioning as gettering sites in a bulk region on an earlier stage of a heat treatment in a device process.

FIG.5

EP 1 975 990 A1

## Description

TECHNICAL FIELD

The present invention relates to a method for manufacturing a silicon single crystal wafer that can form a DZ layer having no occurrence of crystal defects from a wafer surface to a fixed depth where a device activation region is formed and can form oxide precipitates serving as gettering sites in the wafer.

BACKGROUND ART

A silicon single crystal wafer that becomes a material of a semiconductor device can be generally fabricated by growing a silicon single crystal based on a Czochralski method (which will be referred to as a CZ method hereinafter) and applying processes such as slicing, polishing, the others to the obtained silicon single crystal ingot.

The silicon single crystal grown based on the CZ method in this manner may produce an oxidation induced stacking fault called OSF that is generated in a ring-like shape when subjected to a thermal oxidation treatment (e.g., at 1100°C for two hours). It has been revealed that a micro defect that is formed during crystal growth and adversely affects device performances (which will be referred to as a grown-in defect hereinafter) is present besides the OSF.

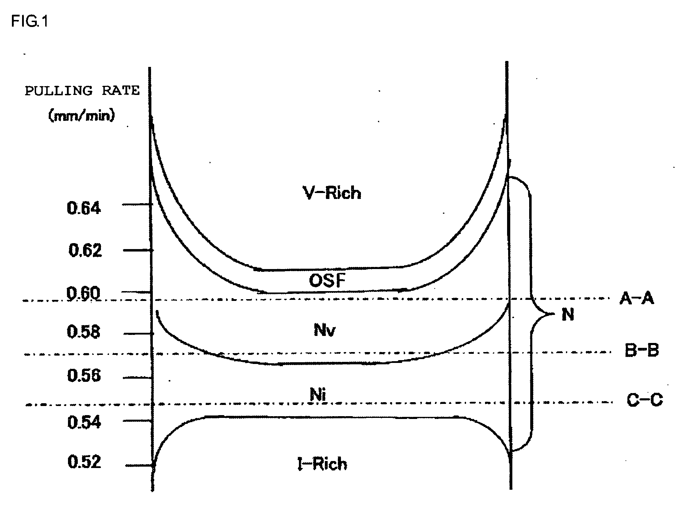

Thus, e.g., Japanese Patent Application Laid-open No. 79889-1999 or Japanese Patent No. 3085146 discloses a single-crystal manufacturing method for obtaining a wafer in which such defects are reduced as much as possible. FIG. 1 shows an example of a relationship between a pulling rate and a defect distribution when a single crystal is grown. This corresponds to an example where V/G as a ratio of a pulling rate V (mm/min) at the time of single crystal growth with respect to an average value G (°C/mm) of an in-crystal temperature gradient in a pulling axis direction in a temperature range from a silicon melting point to 1300°C is changed by varying the pulling rate V (mm/min).

It is generally known that a temperature distribution within the single crystal is dependent on a structure in a CZ furnace (which will be referred to as a hot zone hereinafter) and this distribution rarely varies even if the pulling rate is changed. Therefore, in case of the CZ furnace having the same structure, V/G is associated with a change in pulling rate alone. That is, the pulling rate V and V/G approximately have a direct proportional relationship. Therefore, the pulling rate V is used for a vertical axis shown in Fig. 1.

In a region where the pulling rate V is comparatively high, vacancy type Grown-in defects called COP (Crystal Originated Particle) or FPD (Flow Pattern Defect) that are voids where vacancies each of which is a point defect called a vacancy (Vacancy: hereinafter, called Va) are agglomerated exist in all the areas in a radial direction of a crystal, and it is called V-Rich region.

As a result, when the pulling rate V is slightly lowered, OSFs are annularly generated from a periphery of a crystal, and the OSFs shrink toward the center as the pulling rate V is lowered, and the OSFs are eventually annihilated at the crystal center.

When the pulling rate is further reduced, Neutral (which will be referred to as N hereinafter) region having less excess and deficiency of Va or an interstitial type point defect called Interstitial Silicon (which will be referred to as I hereinafter) is present. It has been revealed that, since this N region has unevenly distributed Va or I but has a saturated concentration or a lower concentration, an agglomerated defect like the COP or the FPD does not exist, or presence of the defect cannot be detected by a current defect detection method.

This N region is classified into Nv region where Va is dominant and Ni region where I is dominant.

When the pulling rate V is further reduced, I is supersaturated, so that L/D (Large Dislocation: an abbreviation of a large dislocation loop, e.g., LSEPD or LEPD) defects each considered as a dislocation loop where I is agglomerated are produced at a low density, and this region is called I-Rich region.

As a result, a wafer which has a whole area in a radial direction serving as the N region and has very small number of defects can be obtained by slicing a single crystal pulled while controlling V/G in a range where the N region is formed from the center of the crystal toward the entire region in the radial region and by polishing it.

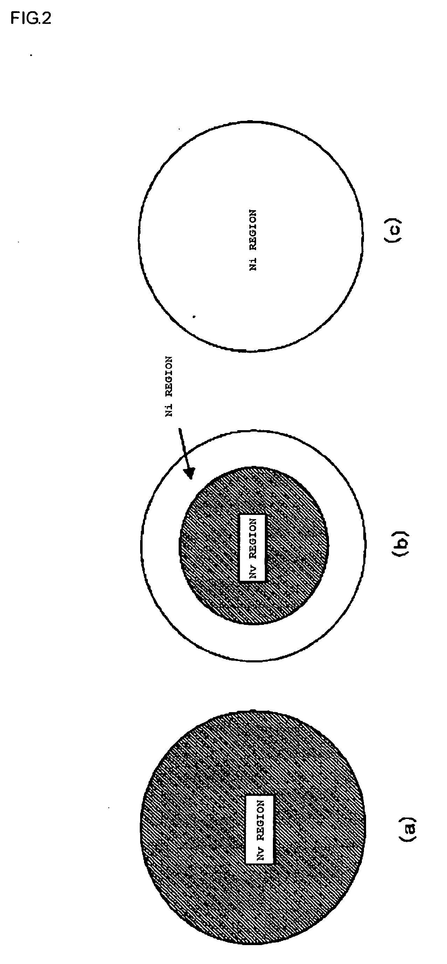

For example, a wafer sliced out from a position A-A in FIG. 1 becomes a wafer, which has a whole area serving as the Nv region as shown in FIG. 2(a). FIG. 2(b) shows a wafer sliced out from a position B-B in FIG. 1, and the Nv region is present at a wafer central portion whilst the Ni region is present at a peripheral portion.

FIG. 2(c) shows a wafer sliced out from C-C in FIG. 1, and the wafer which has a wafer whole area formed of the Ni region can be obtained.

When Grown-in defects that are present in the V-Rich region or the I-Rich region appear on the wafer surface, such defects have an adverse effect, e.g., a reduction in an oxide dielectric breakdown voltage on device characteristics in a case where an MOS (Metal Oxide Semiconductor) structure of a device is formed, and hence no presence of such defects in a wafer surface layer is desired.

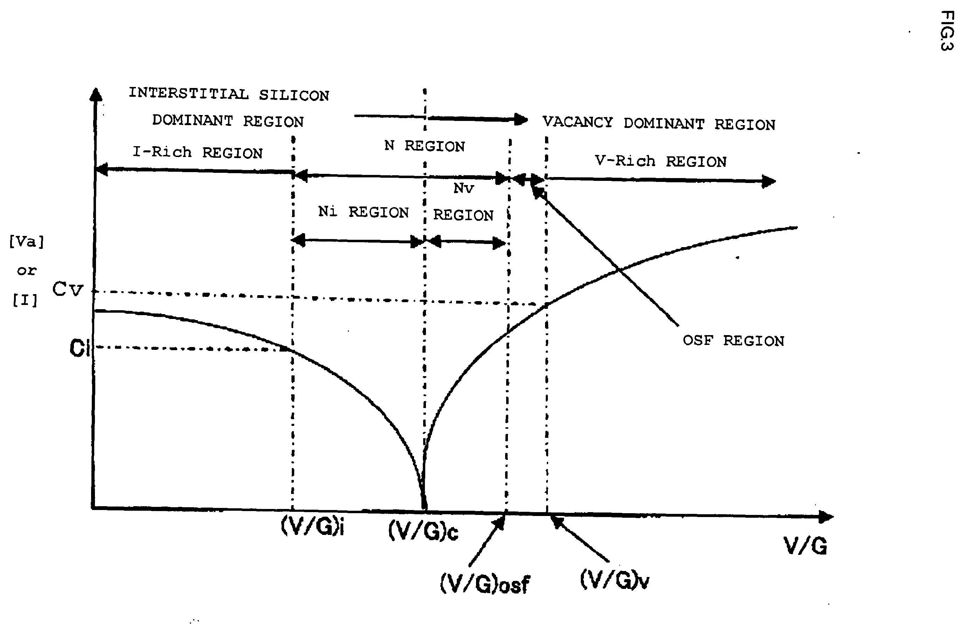

FIG. 3 schematically shows a relationship between V/G, and a Va concentration and an I concentration, and this relationship is called a Voronkov theory and represents that a boundary between a vacancy region and an interstitial silicon region is determined by V/G.

In more detail, a region where Va is dominant is formed when V/G is equal to or above a critical point (V/G)c, and a region where I is dominant is formed when the same is equal to or below the critical point. That is, (V/G)c represents a V/G value with which Va and I have the same concentration.

Since V/G is equal to or below (V/G)i and interstitial silicon type point defects I have a saturated concentration Ci or a higher concentration in 1-Rich region in FIG. 3, this region is a region where an agglomerate of interstitial silicon point defects, i.e., a grown-in defect of L/D is generated.

Since V/G is equal to or above (V/G)v and vacancies Va have a saturated concentration Cv or a higher concentration in V-Rich region, this is a region where an agglomerate of vacancies, i.e., a grown-in defect of, e.g., COP is generated.

N region means a neutral region ((V/G)i to (V/G)osf) where an agglomerate of vacancies or an agglomerate of interstitial silicon type point defects is not present.

Further, OSF region ((V/G) osf to (V/G)v) is usually present to be adjacent to this N region.

Meanwhile, a silicon wafer usually contains oxygen of approximately 7 to $10 \times 10^{17}$ atoms/cm$^3$ (a conversion factor defined by JEIDA: Japanese Electronic Industry Development Association is used) in a supersaturation state.

Therefore, when a heat treatment is applied to such a silicon wafer in, e.g., a device process, supersaturated oxygen in the silicon wafer is precipitated as an oxide precipitate. Such an oxide precipitate is called BMD (Bulk Micro Defect). This BMD becomes a problem when it is generated in a device activation region in a wafer since the BMD adversely affects on device characteristics, e.g., junction leakage but, on the other hand, the BMD is effective when it is present in a bulk outside the device activation region since the BMD functions as a gettering site that captures a metal impurity.

Therefore, in manufacture of a silicon wafer, the BMD is formed in a bulk of the wafer, and a defect-free region (a denuded zone; which will be referred to as a DZ layer hereinafter) where the BMD or the grown-in defect is not present must be maintained near a wafer surface, which is a device activation region.

In recent years, a method for performing an RTP (Rapid Thermal Process) treatment with respect to the silicon wafer (a rapid thermal annealing) has been proposed as a method for manufacturing a silicon wafer that is designed to have the BMD formed in a bulk deeper than a device activation region and have a gettering ability while maintaining a DZ layer with no BMD near a wafer surface as the device activation region by performing a heat treatment, e.g., a subsequent device process although the BMD is not generated in a wafer on a silicon wafer shipment stage (see, e.g., Japanese Patent Application Laid-open No. 2001-203210, USP No. 5401669, and PCT national publication No. 2001-503009).

This RTP processing is a heat treatment method characterized by rapidly increasing a temperature of a silicon wafer from a room temperature in a nitridating atmosphere such as $N_2$ or $NH_3$ or a mixed gas atmosphere containing these gases or a non-nitridating atmosphere such as Ar or $H_2$ at a heating rate of, e.g., 50°C/second, heating and maintaining the silicon wafer at a temperature of approximately 1200°C for several-ten seconds, then rapidly cooling the silicon wafer at a cooling rate of, e.g., 50°C/second.

A mechanism of forming the BMD by performing an oxygen precipitation heat treatment after the RTP processing will now be briefly explained.

First, in the RTP processing, injection of Va occurs from a wafer surface while maintaining a high temperature of 1200°C in, e.g., an $N_2$ atmosphere, redistribution due to diffusion of Va and annihilation due to recombination with I occur while performing cooling in a temperature range of 1200°C to 700°C at a cooling rate of, e.g., 50°C/second. As a result, Va is non-uniformly distributed in a bulk.

When, e.g., an oxygen precipitation heat treatment is performed with respect to the wafer in such a state, oxide precipitates are clustered in a region having a high Va concentration, and the clustered oxide precipitates grow to form BMDs. When the oxygen precipitation heat treatment is performed with respect to the silicon wafer subjected to the RTP processing in this manner, the BMDs having a distribution in a wafer depth direction are formed in accordance with a concentration profile of Va formed by the RTP processing.

Therefore, a desired Va concentration profile can be formed in the silicon wafer by performing the RTP processing while controlling its conditions, e.g., an atmosphere, a maximum temperature, a holding time, and others, and the oxygen precipitation heat treatment is then carried out with respect to the obtained silicon wafer, thereby manufacturing a silicon wafer having a desired DZ layer thickness and a BMD profile in a depth direction.

Since a desired DZ layer thickness or a desired BMD profile can be obtained by newly injecting Va in the RTP processing in this manner, this process is effective, but a reduction in temperature/time is prominent in the recent device process, forming the BMDs during the device process is becoming difficult even in a wafer subjected to the RTP processing, which is a problem.

As a countermeasure, a precipitation heat treatment is carried out after the RTP processing to grow/stabilize oxide precipitate nuclei, thus forming sufficient BMDs in the device process. However, as disclosed in, e.g., Japanese Patent Application Laid-open No. 2001-203210, there is a problem that a long-time heat treatment is required and a wafer manufacturing cost is increased.

Since a heat treatment time is a very short time in the RTP processing, when grown-in defects such as COPs or L/D are present in a silicon wafer as a material, such defects cannot be sufficiently annihilated. As a result, when the silicon wafer having the grown-in defects is subjected to the RTP processing, a region where BMDs are not formed can be assured from a surface to a given depth, and the grown-in defects can be annihilated in a very shallow region in the surface by the RTP processing, but the grown-in defects are still present in a deeper region, and defects in an entire device activation region cannot be annihilated. Therefore, there is an inconvenience that device characteristics are reduced.

Thus, for example, Japanese Patent Application Laid-open No. 2001-203210 proposes a method for slicing a single crystal in N region having no agglomeration of Va or I to obtain a silicon wafer and performing the RTP processing with respect to the wafer having a whole area in a radial direction formed of as the N region. When a crystal having a whole area formed of as the N region is used, a desired wafer, which has no defect in a surface layer but has BMDs in a bulk can be obtained after the RTP processing. However, even though the wafer having the whole area in the radial direction formed of the N region is used as a material, device characteristics may be lowered in the wafer after the RTP processing in some cases.

DISCLOSURE OF INVENTION

In view of the above-explained problems, it is an object of the present invention to provide a manufacturing method for enabling inexpensively manufacturing a silicon wafer that can assure a DZ layer having a sufficient depth in a wafer surface layer region and can also assure in a bulk region a sufficient quantities of oxide precipitates that function as gettering sites on an earlier stage of a heat treatment in a device process.

To achieve this object, the present invention provides a method for manufacturing a silicon single crystal wafer by which a silicon single crystal ingot is pulled based on a Czochralski method and a rapid thermal annealing is performed with respect to a wafer that is sliced out from the silicon single crystal ingot and has a whole area in a radial direction formed of N region, wherein a heat treatment at 800 to 1100°C as a heat treatment temperature for two hours or below as a heat treatment time is carried out after the rapid thermal annealing while adjusting the heat treatment temperature and the heat treatment time so that at least diffusion distances of vacancies as point defects injected by the rapid thermal annealing become longer than diffusion distances of the vacancies by a heat treatment performed at 800°C for 30 minutes, thereby annihilating a vacancy type defect.

In this manner, the silicon single crystal ingot is pulled up based on the Czochralski method, the rapid thermal annealing is performed with respect to the wafer which is sliced out from the ingot and has the whole area in the radial direction formed of the N region, then the heat treatment is carried out with respect to this wafer having the whole area in the radial direction formed of the N region at the heat treatment temperature of 800 to 1100°C for the heat treatment time (a holding time) of two hours or below. When this heat treatment is carried out while adjusting the heat treatment temperature and the heat treatment time in such a manner that at least the diffusion distances of the vacancies as the point defects injected by the rapid thermal annealing become longer than the diffusion distances of the vacancies by a heat treatment performed at 800°C for 30 minutes, a vacancy concentration in the surface layer can be reduced, thereby annihilating the vacancy type defect. Since the vacancy type defect generated in the rapid thermal annealing can be readily annihilated by the short-time heat treatment in this manner, the entire N region can be used as a material without increasing a cost, thus improving a yield. At the same time, since oxide precipitate nuclei in a bulk region can be grown/stabilized by the short-time heat treatment, BMDs can be sufficiently formed even during a recent device process having a reduced temperature/time. Therefore, it is possible to inexpensively obtain a high-quality silicon single crystal wafer in which a DZ layer is formed in the surface layer region and oxide precipitates serving as gettering sites are sufficiently formed in the bulk region.

At this time, the silicon single crystal ingot can be pulled up in such a manner that the whole area in the radial direction becomes Nv region.

As explained above, in the conventional technology, when the silicon single crystal ingot is pulled up in such a manner that the whole area in the radial direction becomes the Nv region in particular and the wafer having the whole area in the radial direction formed of the Nv region is sliced out to be used as a material, device characteristics may be reduced in the wafer after the RTP in some cases. However, according to the present invention, even if the ingot is pulled up in such a manner that the whole area in the radial direction becomes the Nv region, the vacancy type defects generated after the RTP can be effectively annihilated in the sliced wafer having the whole area in the radial direction formed of the Nv region, thereby preventing the device characteristics from being reduced. Therefore, the entire N region including the Nv region can be used as a material, and a production efficiency can be improved. Furthermore, since oxygen precipitation readily occurs in the Nv region, this region has a high gettering ability.

Moreover, it is preferable that the silicon single crystal ingot is doped with nitrogen in a concentration of $1 \times 10^{11}$ to $1 \times 10^{15}$ atoms/cm$^3$ and/or carbon in a concentration of $1 \times 10^{16}$ to $1 \times 10^{17}$ atoms/cm$^3$ when pulling the silicon single crystal ingot.

Doping with silicon single crystal ingot with nitrogen in the concentration of $1 \times 10^{11}$ atoms/cm$^3$ or above in this manner enables distinguishing expansion of the N region when pulling the silicon single crystal ingot and a promoting effect of oxygen precipitation. Additionally, when the concentration is set to $1 \times 10^{15}$ atoms/cm$^3$ or below, an increase in crystal manufacturing cost can be avoided without interrupting single-crystallization of silicon.

Further, when the silicon single crystal ingot is doped with carbon in the concentration of $1 \times 10^{16}$ or above, oxygen precipitation can be effectively facilitated, and carbon itself can function as a gettering site. At this time, when the concentration is set to $1 \times 10^{17}$ atoms/cm$^3$ or below, a reduction in lifetime of the wafer due to carbon can be avoided.

Furthermore, it is preferable that the silicon single crystal ingot is doped with oxygen in a concentration of 8 ppm to 15 ppm when pulling the silicon single crystal ingot.

When the oxygen concentration is set to 8 ppm or above when pulling the silicon single crystal ingot in this manner, an oxygen precipitation heat treatment after the rapid thermal annealing enables forming a sufficiently thick DZ layer in the wafer surface layer region having a relatively low vacancy concentration and also effectively forming oxide precipitates in the bulk region of the wafer having a high vacancy concentration. Moreover, when the concentration is set to 15 ppm or below, the DZ layer can be sufficiently assured in the surface layer region of the wafer, precipitates can be sufficiently formed in the bulk portion to provide a strong gettering effect, and precipitates are not formed more than necessity. Therefore, it is possible to manufacture a high-quality wafer, which has a gettering ability and does not reduce device characteristics.

Additionally, it is preferable that the rapid thermal annealing is carried out in a non-oxidizing atmosphere.

As explained above, in the method for manufacturing a silicon wafer according to the present invention, it is preferable to perform the rapid thermal annealing in the non-oxidizing atmosphere, and $N_2$, $NH_3$, $NO$, $N_2O$, or $N_2O_2$ can be used as an ambient gas to provide a nitridating atmosphere, for example. Further, for example, $H_2$, $Ar$, or $He$ can be used to provide a non-nitridating atmosphere. Furthermore, the rapid thermal annealing can be carried out in an atmosphere in which the nitridating atmosphere and the non-nitridating atmosphere are mixed.

When such a method for manufacturing a silicon single crystal wafer according to the present invention is adopted, defects generated after the rapid thermal annealing can be annihilated in the subsequent heat treatment, and stable oxide precipitate nuclei can be formed in the bulk of the wafer during a device process. Moreover, a crystal region that can be used as a material can be formed of the whole N region, thereby improving a yield. The high-quality silicon single crystal wafer that can assure the DZ layer having no defect in the surface layer region of the wafer serving as a device activation region and can also sufficiently form oxide precipitates functioning as gettering sites in the bulk region can be manufactured without increasing a cost.

BRIEF DESCRIPTION OF DRAWINGS

FIG. 1 is a schematic explanatory drawing showing an example of a relationship between a pulling rate and a defect distribution when a silicon single crystal ingot is grown;

FIG. 2 is a schematic view showing a radial defect distribution of a wafer obtained by slicing the silicon single crystal ingot in a radial direction;

FIG. 3 is a schematic explanatory drawing showing a relationship between V/G and a Va concentration and an I concentration;

FIG. 4 is a schematic explanatory drawing showing a relationship between V/G and a Va concentration and an I concentration before an RTP processing and after the RTP processing;

FIG. 5 is a graph showing a relationship between a heat treatment temperature of a rapid thermal annealing and an oxide dielectric breakdown voltage measurement result;

FIG. 6 is a schematic view of a radial defect distribution showing a result of an oxide dielectric breakdown voltage measurement in a comparative example; and

FIG. 7 is a graph showing a relationship between a heat treatment time and a heat treatment temperature in a heat treatment after the rapid thermal annealing and an oxide dielectric breakdown voltage measurement result.

BEST MODE FOR CARRYING OUT THE INVENTION

An embodiment according to the present invention will now be explained hereinafter, but the present invention is not restricted thereto.

As a method for manufacturing a wafer that has a DZ layer in a surface layer region and BMDs in a bulk region and can be provided with a gettering ability, there is a method for performing an RTP processing to a wafer to newly inject Va, thereby obtaining a desired DZ layer and a desired BMD profile. However, with a reduction in temperature/time of a recent device process, forming BMDs during the device process is difficult, and up to now, oxide precipitate nuclei are grown/stabilized by an oxygen precipitation heat treatment, but this heat treatment requires a long time, resulting in an increase in wafer manufacturing cost.

Thus, for example, there is a method for slicing N region of a single-crystal ingot where an agglomerate of Va or I is not present and performing an RTP processing with respect to a wafer having a whole area in a radial direction formed of the N region. However, even if the silicon wafer having the N region containing no grown-in defects therein is prepared, there is a problem that an oxide dielectric breakdown voltage is lowered when the oxide dielectric breakdown voltage is measured after the RTP processing.

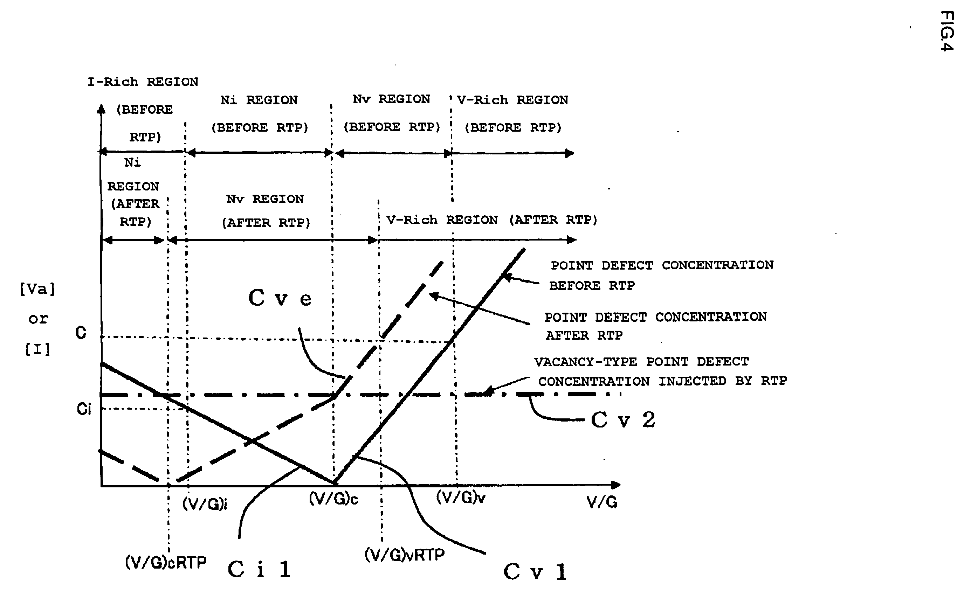

Here, a factor of this reduction in oxide dielectric breakdown voltage will be first explained. Although this factor is not clear, the present inventor has considered that this factor occurs based on the following mechanism. FIG. 4 is a schematic explanatory drawing for explaining the mechanism and showing changes in a defect region in a wafer before and after the RTP processing. It is to be noted that, in this explanation of the mechanism, since OSF region basically has no concern, the OSF region is not shown for simplicity.

As shown in FIG. 4, before a rapid thermal annealing, assuming that a vacancy concentration of a silicon wafer is $Cv1$, an interstitial silicon type point defect concentration is $Ci1$, and respective saturated concentrations are $Cv$ and $Ci$, values of V/G at intersections of $Cv1$ and $Cv$ and of $Ci1$ and $Ci$, i.e., $(V/G)v$ and $(V/G)i$ are boundaries between V-Rich region and N region and between the N region and I-Rich region, respectively. Further, a boundary between Nv region and Ni region is determined as a critical value $(V/G)c$.

Furthermore, $(V/G)vRTP$ and $(V/G)cRTP$ are determined as boundaries between the V-Rich region and the N region after the RTP and between the Nv region and the Ni region after the RTP, respectively.

Here, assuming that a vacancy concentration injected by the RTP processing is $Cv2$ after the RTP processing, since I and Va form a pair to be annihilated, a net vacancy concentration $Cve$ in the silicon wafer after the rapid thermal annealing can be given by the following expression:

$$Cve=Cv1-Ci1+Cv2$$

Therefore, the vacancy concentration after the RTP processing is increased by $Cv2$ in the Nv region (which can be approximated as $Ci1=0$), and it becomes a vacancy concentration obtained by subtracting the I concentration $Ci1$ that is present from the beginning from the vacancy concentration $Cv2$ injected by the RTP processing in the Ni region (which can be approximated as $Cv1=0$).

Therefore, as for the wafer in a region where V/G is equal to $(V/G)vRTP$ or above among Nv region in a state before RTP (Nv region (before RTP)), the net vacancy concentration becomes the saturated concentration $Cv$ or a higher concentration by the RTP processing, and hence it can be considered that an agglomeration of vacancies is produced to form a vacancy type defect and become the V-Rich region (V-Rich region (after RTP)).

Based on such a consideration, a reason that a reduction in oxide dielectric breakdown voltage is considerable after the RTP processing in a region close to OSF region among Nv region (before RTP), i.e., a region where an agglomeration of Va is not generated but a Va concentration is relatively high can be understood as a factor that the vacancy concentration $Cv1$ present in the silicon wafer before the rapid thermal annealing is high in this region, a supersaturation degree of the vacancy concentration before the rapid thermal annealing is higher than that in Nv region (before RTP) close to Ni region (before RTP), and hence vacancies are injected by the RTP to facilitate occurrence of an agglomeration of point defects.

Moreover, further examining the vacancy type defect produced by agglomerating Va after RTP, the present inventor has revealed that a size of this vacancy type defect is very small and this defect can be easily annihilated by a short-time heat treatment, thereby bringing the present invention to completion.

In the method for manufacturing a silicon single crystal wafer according to the present invention obtained from the above-explained studies, a silicon single crystal ingot is pulled up based on a Czochralski method, a rapid thermal annealing is performed with respect to a wafer that is sliced out from the silicon single crystal ingot and has a whole area in a radial direction formed of N region, and then a heat treatment is further performed at a heat treatment temperature of 800 to 1100°C for two hours or below as a heat treatment time in order to annihilate vacancy type defects generated by the rapid thermal annealing.

It is to be noted that, in the manufacturing method according to the present invention, a pulling apparatus or a rapid thermal annealing apparatus equal to that in the conventional technology can be used.

First, in pulling the silicon single crystal ingot based on the Czochralski method, for example, a pulling rate is appropriately adjusted to control V/G so that a wafer having a whole area in a radial direction formed of the N region can be sliced out from the pulled silicon single crystal ingot, and pulling is carried out in such a manner that a defect region in the silicon single crystal ingot can have a distribution meeting its purpose. A control method for V/G and others are not restricted in particular. It is good enough to perform control by adjusting the pulling rate as explained above or changing an in-furnace structure, and enabling slicing out the wafer having the N region from the ingot can suffice.

At this time, in the present invention, pulling can be performed in such a manner that the whole area in the radial direction becomes the Nv region that is a region where vacancies as point defects are dominant. As explained above with reference to FIG. 4, a concentration of vacancies is high in the Nv region, especially the Nv region close to the OSF region, and when the rapid thermal annealing is carried out with respect to such a wafer, vacancies are newly injected by the rapid thermal annealing, and the vacancies may be agglomerated to form a vacancy type Grown-in defect such as a COP even if the N region is provided before the rapid thermal annealing.

However, since a size of the vacancy type defect generated by the rapid thermal annealing in this manner is very small, when the vacancies are diffused by performing the heat treatment like the present invention after the RTP processing, a vacancy concentration in a surface layer is lowered, thereby annihilating the vacancy type defect. Therefore, device characteristics can be effectively prevented from being reduced, namely, the wafer having the Nv region can be effectively used as a material, thereby increasing a yield and improving a yield ratio/productivity.

Moreover, when pulling the silicon single crystal ingot, doping with nitrogen in a concentration of $1 \times 10^{11}$ to $1 \times 10^{15}$ atoms/cm$^2$ is beneficial. Doping with nitrogen in such a concentration range enables distinguishing expansion of the N region when pulling the ingot or a promoting effect of oxygen precipitation without interrupting single-crystallization of silicon.

Alternatively, the silicon single crystal ingot can be doped with carbon at a concentration of $1 \times 10^{16}$ to $1 \times 10^{17}$ atoms/cm$^3$. Doping with carbon in such a concentration range enables effectively facilitating oxygen precipitation and allowing carbon itself to function as a gettering site without reducing a lifetime of the wafer.

Additionally, when an oxygen concentration of the wafer sliced out from the silicon single crystal silicon is set to fall within the range of 8 ppm to 15 ppm, a DZ layer with a sufficient thickness can be assured in a surface layer region of the wafer, and oxide precipitates can be effectively formed in a bulk region after an oxygen precipitation heat treatment. Therefore, a high-quality wafer having a sufficient gettering ability can be provided without reducing device characteristics, e.g., an oxide dielectric breakdown voltage.

Then, a heat treatment temperature is changed to perform a rapid thermal annealing with respect to such a wafer. As an atmosphere in the rapid thermal annealing at this time, a non-oxidizing atmosphere is preferable and, for example, N$_2$, NH$_3$, NO, N$_2$O, or N$_2$O$_2$ can be used to provide a nitridating atmosphere. Alternatively, H$_2$, Ar, or He can be used, or an atmosphere in which these elements are mixed can be provided, and the atmosphere is not restricted in particular as long as it is a non-oxidizing atmosphere.

It is to be noted that, when a heat treatment temperature in this rapid thermal annealing is set to, e.g., 1100°C or above, oxide precipitates functioning as gettering sites can be readily formed. Additionally, when this temperature is set to 1300°C or below, the wafer can be uniformly heated in a radial direction, occurrence of slip due to a thermal stress can be effectively avoided, and adopting such a temperature range enables suppressing metal contamination with respect to the wafer.

After the rapid thermal annealing is carried out with respect to the wafer that is obtained from the silicon single crystal ingot and has the whole area in the radial direction formed of the N region as explained above, a heat treatment is further performed in the present invention.

As explained above, this heat treatment is carried out to annihilate the vacancy type defect generated due to the rapid thermal annealing. Specifically, this is a heat treatment with a heat treatment temperature of 800 to 1100°C and a heat treatment time of 2 hours or below, and this heat treatment is performed while adjusting the heat treatment temperature and the heat treatment time so that at least diffusion distances of vacancies as point defects injected by the rapid thermal annealing become longer than diffusion distances of vacancies by a heat treatment at 800°C for 30 minutes.

In the vacancy type defect formed by agglomerating the vacancies as point detects based on the rapid thermal annealing, when the heat treatment temperature is less than 800°C, the vacancies are hardly diffused, and hence a long time is required to annihilate the vacancy type defect. Therefore, a temperature of the heat treatment must be set to 800°C or above in order to suppress an increase in cost required for the heat treatment and efficiently annihilate the vacancy type defect. Further, when the heat treatment time is 800°C, the heat treatment time must be set to at least 30 minutes or above to provide sufficient diffusion distances of the vacancies and assuredly annihilate the vacancy type defect.

Furthermore, since a diffusion constant of the vacancy is increased as a temperature rises, when performing the heat treatment at a high temperature exceeding 800°C, it is good enough to carry out this heat treatment while adjusting a heat treatment temperature and a heat treatment time so that the diffusion distance becomes longer than a diffusion distance in the example where the wafer is held at 800°C for 30 minutes.

However, since a temperature at which the wafer is put into a heat treatment furnace is usually 800°C or below, the temperature is increased to a target heat treatment temperature at, e.g., 5°C/min after putting the wafer into the furnace, the temperature is held for a fixed time, and then the temperature is reduced to, e.g., approximately 700°C at about 5°C/min, a rise of the heat treatment temperature enables obtaining an effect of reducing a holding time but, on the other hand, an influence of extension of a temperature increasing/temperature reducing time becomes large, so that a total heat treatment time from putting the wafer into the furnace to ejecting the same after the heat treatment is prolonged, thereby possibly leading to an increase in cost.

Therefore, as a result of comprehensively judging in terms of the cost or the effect obtained by a rise of the temperature, setting a maximum temperature to 1100°C is desirable, and a heat treatment temperature in the heat treatment according to the present invention is set to 800 to 1100°C as explained above. Moreover, a preferable heat treatment temperature range is 900°C or above to less than 1000°C. Additionally, a heat treatment time is set to two hours or below for the same reason. As explained above, the vacancy type defect can be sufficiently annihilated in a short time. Further, adopting the conditions of 1100°C and two hours or below enables preventing metal contamination of the wafer.

Setting such ranges of the temperature and the time enables sufficiently diffusing vacancies based on the rapid thermal annealing and efficiently annihilating the vacancy type defect without increasing a cost more than necessary. Furthermore, oxide precipitate nuclei can be grown/stabilized, a sufficient quantity of BMDs can be formed in the bulk region even in a recent device process having a reduced time/reduced temperature.

As explained above, according to the method for manufacturing a silicon single crystal wafer of the present invention, the entire N region (especially the Nv region) can be used as a material, and hence a yield or productivity can be improved. That is, even if vacancies are injected to generate the vacancy type defect when performing the RTP processing by using the wafer having the whole area formed of the N region, the subsequent heat treatment enables annihilating this vacancy type defect, thereby obtaining the wafer with a high breakdown voltage in which no grown-in defects are formed. At this time, the DZ layer with a sufficient thickness is formed in the surface layer region as the device activation region, and the high-quality silicon single crystal wafer that can effectively avoid a reduction in device characteristics even after the rapid thermal annealing can be inexpensively obtained while suppressing a cost. At the same time, since oxide precipitate nuclei can be grown/stabilized in the bulk, the wafer in which a sufficient quantity of BMDs can be formed can be provided even in a recent device process having a reduced time/reduced temperature.

The present invention will now be explained in more detail based on examples and comparative examples, but the present invention is not restricted thereto.

(Example 1/Comparative Example 1)

The same single crystal pulling apparatus as that used in the conventional technology was used to grow a silicon single crystal ingot by continuously reducing a pulling rate from 0.7 mm/min to 0.5 mm/min while controlling to obtain a diameter of 210 mm.

In this case, a defect distribution of a cross section of the ingot parallel to a pulling axis is as shown in Fig. 1.

Thus, a single crystal pulling apparatus having the same hot zone was used to pull a silicon single crystal ingot while controlling so that a pulling rate becomes 0.595 mm/min (the position of A-A in FIG. 1), and slice the silicon single crystal ingot in a radial direction, thereby preparing a wafer. A defect distribution of this wafer has Nv region formed on a whole area (which will be referred to as an Nv wafer hereinafter) as shown in FIG. 2(a).

Additionally, a silicon single crystal ingot was pulled up while controlling so that a pulling rate becomes 0.57 mm/min (the position of B-B in FIG. 1), and the silicon single crystal ingot was sliced in a radial direction, thereby preparing a wafer. A defect distribution of this wafer has Nv region provided at a central portion of the wafer and Ni region provided at a peripheral portion of the wafer (which will be referred to as an NvNi mixed wafer hereinafter) as shown in FIG. 2(b).

It is to be noted that, at the time of pulling the ingot, the ingot was doped with nitrogen in a concentration of $1 \times 10^{11}$ atoms/cm$^3$. Further, an oxygen concentration of each sliced-out wafer was 12 ppm (JEIDA).

A commercially available rapid thermal annealing apparatus (AST-2800 manufactured by Steag) was used to rapidly increase a temperature of each of these wafers from a room temperature in a mixed atmosphere containing $NH_3$ with a flow volume of 0.5 1/min and Ar with a flow volume of 4 1/min at a heating rate of 50°C/min, hold each wafer at a maximum temperature of 1160 to 1200°C for 10 seconds, and then rapidly cool each wafer at a cooling rate of 50°C/ second. Thereafter, the wafers were classified into wafers subjected to a heat treatment in an $N_2$ atmosphere at 800°C for one hour (Example 1) and wafers that were not subjected to a heat treatment after the RTP processing like the heat treatment of Example 1 (Comparative Example 1), a gate oxide film with a thickness of 25 nm was formed on each wafer surface, and an oxide dielectric breakdown voltage (TDDB) of each wafer was measured.

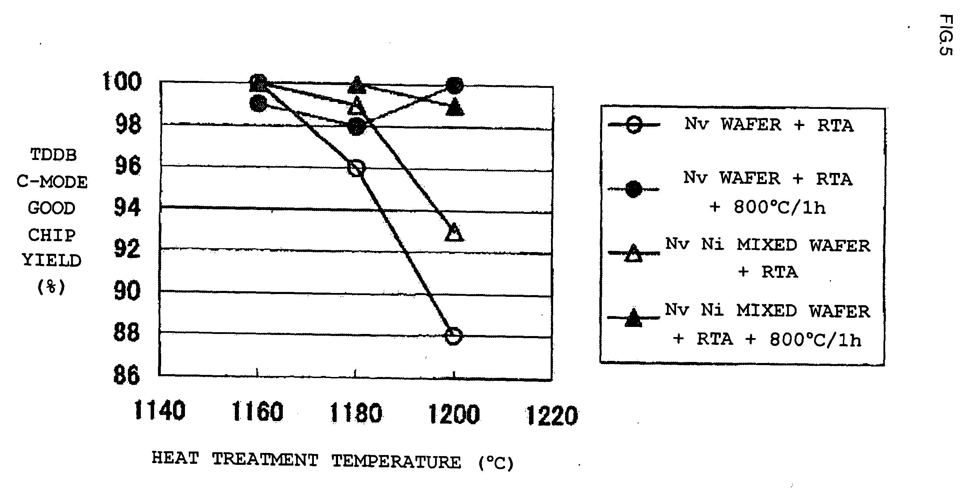

As results of Example 1 and Comparative Example 1, FIG. 5 and Table 1 show a relationship between a heat treatment temperature in the rapid thermal annealing and the oxide dielectric breakdown voltage (a good chip yield of a C mode as a true failure mode of the oxide film).

[Table 1]

| Heat treatment temperature (°C) | | 1160 | 1180 | 1200 |
|---|---|---|---|---|
| Good chip yield (%) | Nv wafer + RTA | 100 | 96 | 88 |
| | Nv wafer + RTA + 800°C/1h | 99 | 98 | 100 |
| | Nv Ni mixed wafer + RTA | 100 | 99 | 93 |
| | Nv Ni mixed wafer + RTA + 800°C/1h | 100 | 100 | 99 |

As apparent from FIG. 5 and Table 1, first, in Example 1, the good chip yields of the Nv wafer and the NvNi mixed wafer indicate high values of 98 to 100%, which are substantially, equal to each other irrespective of the heat treatment temperature in the rapid thermal annealing.
On the other hand, in Comparative Example 1, the good chip yields of both the Nv wafer and the NvNi mixed wafer are reduced when the heat treatment temperature in the rapid thermal annealing is increased. Furthermore, comparing the good chip yields of the Nv wafer and the NvNi mixed wafer, the Nv wafer has a lower value.
Moreover, comparing Example 1 with Comparative Example 1, although the good chip yields are substantially equal to each other when the heat treatment temperature in the rapid thermal annealing is 1160°C, a difference begins to appear as the heat treatment temperature is increased, and Example 1 has a considerably higher value than that of Comparative Example 1 when the heat treatment temperature is 1200°C. Specifically, when the heat treatment temperature is 1200°C, the Nv wafer has a value of 100% and the NvNi mixed wafer has a value of 99% in Example 1, the Nv wafer has a value of 88% and the NvNi mixed wafer has a value of 93% in Comparative Example 1, and Example 1 and Comparative Example 1 have a large difference.
It can be considered that a reason that Example 1 can maintain the higher values than Comparative Example 1 without reducing the oxide dielectric breakdown voltage even though the heat treatment temperature in the rapid thermal annealing is increased in this manner is as follows.
As explained above, when the RTP processing is performed with respect to the wafer, Va is injected from the wafer surface. Therefore, when the wafer having the N region, especially the Nv wafer is used as a material, injection of Va causes agglomeration of vacancies as point defects, and a vacancy type defect is highly possibly formed. Additionally, when the vacancy type defect is formed in the surface layer region of the wafer in this manner, the oxide dielectric breakdown voltage is reduced.
However, like Example 1, when the heat treatment at 800 to 1100°C within two hours is performed after the rapid thermal annealing to efficiently diffuse the vacancies injected by the rapid thermal annealing in the present invention, a vacancy concentration in the surface layer is reduced, and the vacancy type defect can be thereby annihilated. Therefore, the oxide dielectric breakdown voltage is hardly lowered. As shown in FIG. 5, the good chip yields in Example 1 are high, and it can be understood that recovery was performed by the heat treatment in a short time. It is to be noted that the heat treatment after the rapid thermal annealing was performed at 800°C for one hour as explained above, and diffusion distances of the vacancies injected by the RTP processing is longer than diffusion distances of the vacancies when a heat treatment was performed at 800°C for 30 minutes.
On the other hand, in Comparative Example 1, since the heat treatment is not performed after the rapid thermal annealing as different from Example 1, it can be considered that the vacancy type defect newly generated by injection of Va in the rapid thermal annealing is still present in the surface layer region and the oxide dielectric breakdown voltage is lowered as compared with Example 1.
It is to be noted that, since an injection concentration of Va is increased as the heat treatment temperature in the rapid thermal annealing rises, a degree of a reduction in oxide dielectric breakdown voltage is increased, and differences between the good chip yields of Example 1 and Comparative Example 1 become large.
Furthermore, since the Nv wafer has a higher single-crystal pulling rate, a region closer to OSF region, and a higher Va concentration in itself than the NvNi mixed wafer, a percentage that the vacancies are agglomerated to form the vacancy type defect by Va injection during the rapid thermal annealing is increased. Therefore, the Nv wafer has the lower good chip yields than the NvNi mixed wafer.

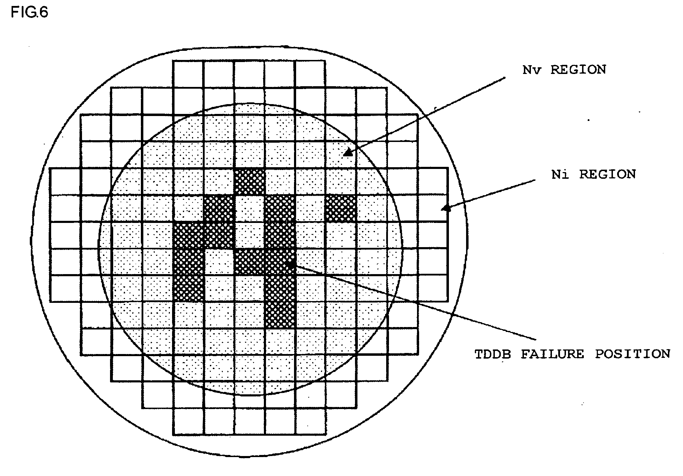

FIG. 6 shows an example of a TDDB measurement result of the NvNi mixed wafer in Comparative Example 1. This wafer has both the Nv region and the Ni region, the Nv region is in the concentric range having a radius of 70 mm from the wafer center, and the Ni region is provided on an outer side thereof. As can be understood from FIG. 6, the reduction in oxide dielectric breakdown voltage occurs in the range of approximately 30 to 40 mm from the wafer center, and it can be revealed that this reduction occurs in only a central portion of the Nv region rather than the entire Nv region.

This wafer is a wafer obtained by slicing the silicon single crystal ingot in the radial direction, and a pulling rate V of the ingot is the same within the wafer surface. However, an average value G (°C/mm) of a temperature gradient in the crystal along a pulling axis direction in the temperature range from a silicon melting point to 1300°C is small at the center of the ingot and increased toward the periphery. Therefore, even though the pulling rate is the same, V/G is increased toward the wafer central portion, and a region closer to the wafer center is a region close to the OSF region even in the same Nv region. In this manner, although agglomeration of Va does not occur on a stage of the ingot in the central region in the Nv region of the wafer in the comparative example, this is a region closer to the OSF region, a concentration of vacancies present in the silicon wafer before rapid thermal annealing is high, a supersaturation degree of a net vacancy concentration after the rapid thermal annealing is higher than that in the Nv region close to the Ni region (i.e., near an outer periphery of the Nv region of the wafer), the vacancies are apt to be agglomerated, and grown-in defects are readily generated.

Moreover, an oxygen precipitation heat treatment was performed with respect to each of the wafers according to Example 1 and Comparative Example 1 at 900°C as a heat treatment temperature for 10 hours as a heat treatment time in an $N_2$ atmosphere, and a BMD density in each bulk was measured.

As a result, a BMD density in the wafer according to Example 1 is $7 \times 10^9$ pieces/cm$^3$ on an average, the same in the wafer according to Comparative Example 1 is $4 \times 10^7$ pieces/cm$^3$, and Example 1 has the higher density. This arises from formation of stable oxide precipitate nuclei due to growth of a cluster of oxide precipitates in the bulk of the wafer based on application of the heat treatment at 800 to 1100°C for two hours or below after the RTP processing like Example 1.

In the wafer obtained by the manufacturing method according to the present invention, more BMDs can be rapidly formed when the above-explained oxygen precipitation heat treatment is performed.

(Example 2/Comparative Example 2)

Then, a single crystal pulling apparatus having the same hot zone as the pulling apparatus used in Example 1 was utilized to pull silicon single crystal ingots while controlling so that a pulling rate becomes 0.595 mm/min (the position of A-A in FIG. 1) and slice the silicon single crystal ingots in a radial direction to prepare Nv wafers. A temperature of each of the Nv wafers was rapidly increased from a room temperature in a mixed atmosphere containing $NH_3$ with a flow volume of 0.5 1/min and Ar with a flow volume of 4 1/min at a heating rate of 50°C/second, the each Nv wafer was held at 1200°C for 10 seconds, and then the temperature of the each Nv wafer was rapidly reduced at a cooling rate of 50°C/second. Subsequently, heat treatments were performed in an $N_2$ atmosphere at various heat treatment temperatures (700°C, 800°C, and 900°C) and for various heat treatment times (10 minutes, 30 minutes, and 60 minutes), and an oxide dielectric breakdown voltage of each wafer was measured.

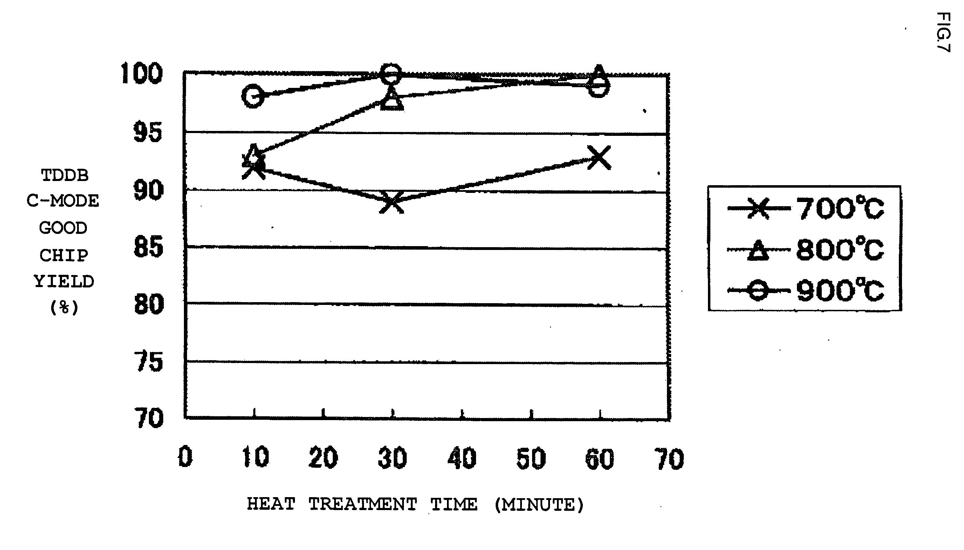

As a result, FIG. 7 and Table 2 show a relationship between a heat treatment temperature, a heat treatment time, and a C-mode good chip yield in the heat treatment after the rapid thermal annealing.

It is to be noted that a good chip yield when the heat treatment was not performed was 88%.

[Table 2]

| Heat treatment time (min) | | 10 | 30 | 60 |
|---|---|---|---|---|
| Good chip yield (%) | 700°C | 92 | 89 | 93 |
| | 800°C | 93 | 98 | 100 |
| | 900°C | 98 | 100 | 99 |

Here, first, an example where the heat treatment was carried out at 800°C for 30 minutes will be explained. As shown in FIG. 7, a good chip yield at this time was 98%, it is sufficiently improved as compared with an example where the heat treatment was not performed, and a high-quality wafer in which a reduction in oxide dielectric breakdown voltage is considerably suppressed was obtained.

The Nv wafer prepared as a material corresponds to a wafer sliced out from the position of A-A in FIG. 1, and this wafer has a region close to OSF region in Nv region. It can be considered that each crystal defect formed by applying the rapid thermal annealing to the wafer having this region is larger than each crystal defect formed in a wafer having a region with a lower pulling rate, i.e., a region with a lower vacancy concentration. Therefore, annihilating defects in the above-explained region means enabling annihilating a vacancy type defect formed in the entire Nv region due to the rapid thermal annealing.

Performing the heat treatment at 800°C for 30 minutes after the rapid thermal annealing enables sufficiently annihilating the vacancy type defect, thereby effectively avoiding a reduction in oxide dielectric breakdown voltage.

Here, when the heat treatment time is further prolonged, diffusion distances of the vacancies become longer, more vacancy type defects can be annihilated, and the good chip yield can be further improved. As shown in FIG. 7, the good chip yield is improved to 100% by the heat treatment performed at 800°C for 60 minutes.

Additionally, since a diffusion constant is increased when heat treatment temperature is higher, the heat treatment carried out in a shorter time enables increasing diffusion distances of vacancies to substantially the same distances as these in case of the heat treatment performed at 800°C for 30 minutes. For example, the good chip yield is improved to 98% by the heat treatment performed at 900°C for 10 minutes. Further, in case of the heat treatment performed at 900°C for 30 minutes or 60 minutes, the good chip yield is 100% or 99%, thereby likewise obtaining a high-quality wafer in which the oxide dielectric breakdown voltage is rarely reduced (this description corresponds to Example 2).

On the other hand, when the heat treatment was performed at 700°C for 10 minutes, 30 minutes, or 30 minutes or the heat treatment was carried out at 800°C for 10 minutes (Comparative Example 2), the good chip yield falls within the range of 89 to 93%, and these are considerably low value as compared with Example 2. In these heat treatments in Comparative Example 2, since vacancies formed by the rapid thermal annealing cannot be sufficiently diffused, annihilation of vacancy type defects is insufficient, and substantially the same effect for annihilating the vacancy type defects as that in the case of the heat treatment performed at 800°C for 30 minutes cannot be obtained.

As explained above in detail, like the present invention, after the RTP processing, by carrying out the heat treatment at 800 to 1100°C for two hours or below so that diffusion distances of vacancies injected by the RTP processing become longer than diffusion distances of the vacancies when the heat treatment is carried out at 800°C for 30 minutes, the vacancy type defects formed by the rapid thermal annealing can be efficiently annihilated, a wafer surface layer region, i.e., a device activation region can be formed as a defect-free region and, at the same time, stable oxide precipitate nuclei can be formed in a bulk. Therefore, when the wafer according to the present invention is subjected to a device process, a wafer in which a reduction in device characteristics is effectively suppressed can be manufactured, and BMDs with a sufficiently density can be formed even in the recent device process having a reduced time/reduced temperature, thus providing a high quality with an excellent gettering ability. Furthermore, since the BMDs can be formed on an earlier stage than that of a conventional wafer, the gettering ability of capturing metal impurities can be demonstrated on an early stage in the device process.

Moreover, the present invention is effective for a wafer that is prepared as a material and has a whole area in a radial direction formed of N region, i.e., in particular, a wafer having Nv region where an oxide dielectric breakdown voltage may be reduced after the RTP processing in a conventional example, and the present invention can be used over the entire Nv region without reducing the oxide dielectric breakdown voltage, thereby considerably improving a production efficiency. Since the above-explained heat treatment after the rapid thermal annealing can be performed in a short time, a manufacturing cost is not increased.

It is to be noted that the present invention is not restricted to the foregoing examples. The foregoing examples are just exemplifications, and any examples that have substantially the same structures as those in the technical concept described in claims of the present invention and demonstrate the same functions and effects are included in the technical scope of the present invention.

**Claims**

1. A method for manufacturing a silicon single crystal wafer by which a silicon single crystal ingot is pulled based on a Czochralski method and a rapid thermal annealing is performed with respect to a wafer that is sliced out from the silicon single crystal ingot and has an whole area in a radial direction formed of N region, wherein a heat treatment at 800 to 1100°C as a heat treatment temperature for two hours or below as a heat treatment time is carried out after the rapid thermal annealing while adjusting the heat treatment temperature and the heat treatment time so that at least diffusion distances of vacancies as point defects injected by the rapid thermal annealing become longer than diffusion distances of the vacancies by a heat treatment performed at 800°C for 30 minutes, thereby annihilating a vacancy type defect.

2. The method for manufacturing a silicon single crystal wafer according to claim 1, wherein the silicon single crystal ingot is pulled in such a manner that the whole area in the radial direction becomes Nv region.

3. The method for manufacturing a silicon single crystal wafer according to claim 1 or 2, wherein the silicon single crystal ingot is doped with nitrogen in a concentration of $1\times10^{11}$ to $1\times10^{15}$ atoms/cm$^3$ and/or carbon in a concen-

tration of $1\times10^{16}$ to $1\times10^{17}$ atoms/cm$^3$ when pulling the silicon single crystal ingot.

4. The method for manufacturing a silicon single crystal wafer according to any one of claims 1 to 3, wherein the silicon single crystal ingot is doped with oxygen in a concentration of 8 ppm to 15 ppm when pulling the silicon single crystal ingot.

5. The method for manufacturing a silicon single crystal wafer according to any one of claims 1 to 4, wherein the rapid thermal annealing is carried out in a non-oxidizing atmosphere.

FIG.1

FIG.2

(a)

NV REGION

(b)

NV REGION

Ni REGION

(c)

Ni REGION

FIG.3

FIG.4

EP 1 975 990 A1

I-Rich REGION (BEFORE RTP)

Ni REGION (BEFORE RTP)

Nv REGION (BEFORE RTP)

V-Rich REGION (BEFORE RTP)

Ni REGION (AFTER RTP)

Nv REGION (AFTER RTP)

V-Rich REGION (AFTER RTP)

$[V_a]$ or $[I]$

C

Ci

C v e

POINT DEFECT CONCENTRATION BEFORE RTP

POINT DEFECT CONCENTRATION AFTER RTP

VACANCY-TYPE POINT DEFECT CONCENTRATION INJECTED BY RTP

C v 2

(V/G)i

(V/G)c

(V/G)v

V/G

(V/G)cRTP

C i 1

(V/G)vRTP

C v 1

FIG.5

FIG.6

Nv REGION

Ni REGION

TDDB FAILURE POSITION

FIG.7

Legend: —✕— 700°C, —△— 800°C, —○— 900°C

Y-axis: TDDB C-MODE GOOD CHIP YIELD (%) — 100, 95, 90, 85, 80, 75, 70

X-axis: HEAT TREATMENT TIME (MINUTE) — 0, 10, 20, 30, 40, 50, 60, 70

## INTERNATIONAL SEARCH REPORT

| | International application No. |
|---|---|
| | PCT/JP2006/325490 |

| A. CLASSIFICATION OF SUBJECT MATTER |
|---|
| *H01L21/322*(2006.01)i, *C30B29/06*(2006.01)i, *C30B33/02*(2006.01)i |

According to International Patent Classification (IPC) or to both national classification and IPC

| B. FIELDS SEARCHED |
|---|
| Minimum documentation searched (classification system followed by classification symbols) |
| H01L21/322, C30B29/06, C30B33/02 |

Documentation searched other than minimum documentation to the extent that such documents are included in the fields searched

| Jitsuyo Shinan Koho | 1922-1996 | Jitsuyo Shinan Toroku Koho | 1996-2007 |
|---|---|---|---|
| Kokai Jitsuyo Shinan Koho | 1971-2007 | Toroku Jitsuyo Shinan Koho | 1994-2007 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y | JP 2004-087592 A (Sumitomo Mitsubishi Silicon Corp.), 18 March, 2004 (18.03.04), Par. Nos. [0016] to [0037]; Figs. 1 to 3 (Family: none) | 1-5 |
| Y | JP 2004-193354 A (Shin-Etsu Handotai Co., Ltd.), 08 July, 2004 (08.07.04), Par. Nos. [0064], [0065] (Family: none) | 1-5 |
| Y | JP 2005-142434 A (Shin-Etsu Handotai Co., Ltd.), 02 June, 2005 (02.06.05), Par. Nos. [0017] to [0019] (Family: none) | 3 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 March, 2007 (20.03.07) | 03 April, 2007 (03.04.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 975 990 A1**

## REFERENCES CITED IN THE DESCRIPTION

### Patent documents cited in the description

- JP 11079889 A
- JP 3085146 B
- JP 2001203210 A
- US 5401669 A
- US 2001503009 W